# EUROPÄISCHE PATENTSCHRIFT

(11) **EP 0 373 357 B1**
(45) Veröffentlichungstag und Bekanntmachung des Hinweises auf die Patenterteilung: **09.02.1994**
(21) Anmeldenummer: 89120603.9
(22) Anmeldetag: 07.11.1989
(51) Int. Cl.: H02P 5/17, H03K 7/10

(54) **Verfahren und Einrichtung zur Regelung fremderregter Gleichstrommotoren**
Method and device to control an externally excited DC motor
Méthode et appareil pour contrôler un moteur à courant continu à excitation séparée

(30) Priorität: 13.12.1988 DE 3841938
(43) Veröffentlichungstag der Anmeldung: 20.06.1990
(73) Patentinhaber: Doehler, Peter, Dipl.-Kfm., D-80539 München (DE)
(72) Erfinder: Doehler, Peter, Dipl.-Kfm., D-80539 München (DE)
(74) Vertreter: Baumann, Eduard, Dipl.-Phys.

(56) Entgegenhaltungen:
- EP-A- 0 055 988
- DE-A- 2 531 255
- IEEE TRANSACTIONS ON INDUSTRY APPLICATIONS vol. IA-11, no. 6, Dezember 1975, US Seiten 695 - 703; J. ZUBEK ET AL: "PULSEWIDTH MODULATED INVERTER MOTOR DRIVES WITH IMPROVED MODULATION"
- FUNKSCHAU. vol. 59, no. 14, 03 Juli 1987, MÜNCHEN DE Seite 59 "IMPULSBETRIEB FUER GLEICHSTROMMOTOREN: PULSBREITENSTELLER"

## Beschreibung

Die Erfindung betrifft ein Verfahren zur Regelung fremderregter Gleichstrommotoren mit den Merkmalen des Oberbegriffes von Patentanspruch 1. Die Erfindung erstreckt sich weiter auf eine Einrichtung zur Durchführung dieses Verfahrens.

Es ist bekannt, eine Drehzahlregelung fremderregter Gleichstrommotoren in der Weise vorzunehmen, daß dem Gleichstrommotor Energie in Impulsen konstanter oder einstellbarer Dauer zugeführt wird und die Auslösung des jeweils nächsten energiezuführenden Impulses dann erfolgt, wenn die generatorische Ankerspannung während der Impulspausen unter einen vorgegebenen Sollwert abgefallen ist (EP-A- 0 055 988).

Während des Anlaufes des Motors bewirkt das Anlegen eines Spannungsimpulses entsprechend der maximal zulässigen Spannung die Entwicklung eines hohen Drehmomentes, derart, daß beim Anlauf des Motors aufgrund der impulsweisen Beaufschlagung des Motorankers ein unruhiger Lauf verursacht wird, was insbesondere dann, wenn der betreffende Motor den Antrieb eines kleinen, leichten Gerätes bildet, etwa der Antrieb einer Modelleisenbahn ist, sehr unerwünscht ist. Außer einer mangelnden Laufruhe während des Hochlaufes sind als Nachteile eine beachtliche Geräuschentwicklung und große Verlustleistung zu nennen.

Ferner ist es bekannt, während der Beaufschlagung des Ankers eines fremderregten Gleichstrommotors mit einem Spannungsimpuls den Strom dadurch zu begrenzen, daß dieser Spannungsimpuls in Unterimpulse mit variierbarem Puls-/Pausenverhältnis aufgeteilt wird, um den Strom auf einen bestimmten Maximalwert zu begrenzen. Zur Messung des Ankerstromes des Motors ist ein Meßwiderstand erforderlich, der je nach Motortype in bestimmter Größe gewählt werden muß. Ferner ist es bei dieser bekannten Regelung nicht möglich, den Motorstrom der jeweiligen Motorbelastung anzupassen, da die Regelung auf einen vorgegebenen Maximalstrom anspricht, der bei der bekannten Schaltung nicht der jeweiligen Motorbelastung angepaßt werden kann.

Durch die Erfindung soll die Aufgabe gelöst werden, ein Verfahren bzw. eine Einrichtung zur Regelung fremderregter Elektromotoren so auszubilden, daß bei impulsweiser Beaufschlagung des Motorankers auch während des Anlaufs des Motors geringe Geräuschentwicklung und ein ruhiger Lauf erzielt werden, geringe Verlustleistungen auftreten und eine Anpassung der Schaltung an unterschiedliche Motortypen und Motorleistungen nicht erforderlich ist.

Diese Aufgabe wird erfindungsgemäß durch die Merkmale des gekennzeichneten Teiles von Patentanspruch 1 bzw. von Patentanspruch 2 gelöst.

Die hier angegebene Schaltung eignet sich hervorragend für die Miniaturisierung und läßt sich auf beschränktem Raum verwirklichen, derart, daß die Schaltung sich bevorzugtermaßen für die Anwendung in Modelleisenbahnsystemen eignet.

Nachfolgend wird die Erfindung anhand eines Ausführungsbeispiels unter Bezugnahme auf die Zeichnung näher erläutert. Es zeigen:
- Fig. 1: ein schematisches Blockschaltbild einer Regelschaltung für fremderregte Gleichstrommotoren und
- Fig. 2: eine Reihe von Diagrammen zur Erläuterung der Wirkungsweise der Schaltung nach Figur 1.

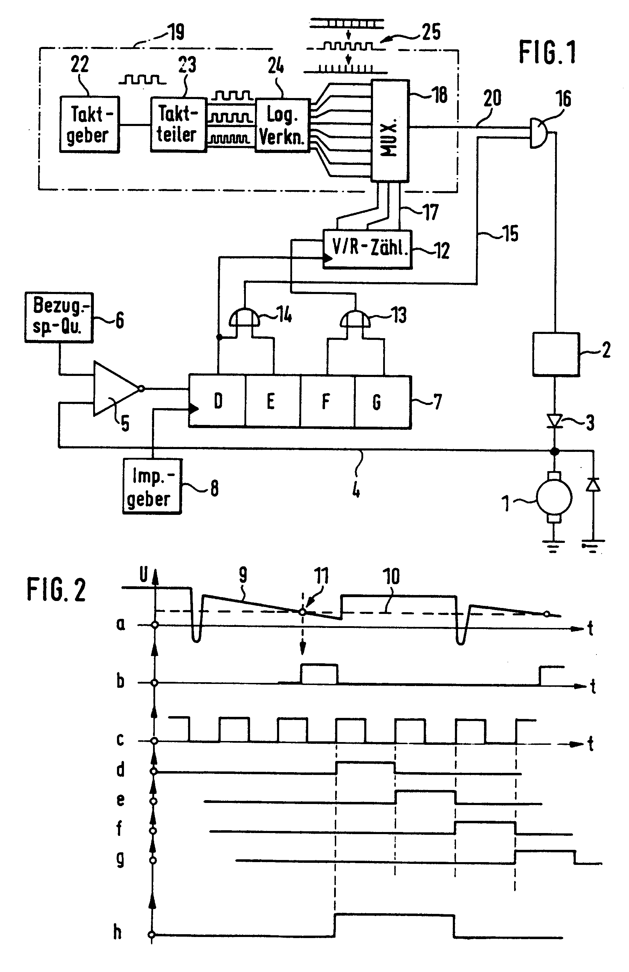

Figur 1 zeigt den Anker 1 eines fremderregten Gleichstrommotors, welcher über einen Pegelumsetzer 2 und einen Gleichrichter 3 mit Gleichspannungsimpulsen beaufschlagt wird. Die während der Impulspausen vom Motoranker abgegebene generatorische Gleichspannung wird über eine Leitung 4 einem Eingang eines Vergleichers 5 zugeführt, dessen anderer Eingang mit einer Bezugsspannungsquelle 6 verbunden ist. Fällt während der Impulspausen der impulsweisen Speisung des Ankers 1 dessen generatorische Ankerspannung unter einen bestimmten Wert ab, so erzeugt der Vergleicher 5 ein Ausgangssignal, das invertiert der ersten Stufe D eines Schieberegisters 7 zugeführt wird, welches mindestens die Stufen D, E, F, G usw., enthält.

Der Takteingang des Schieberegisters 7 wird durch einen Impulsgeber 8 beaufschlagt, der eine Impulsfolge entsprechend Figur 2c erzeugt. Fällt also die in Figur 2a durch die Linie 9 qualitativ dargestellte Spannung des Ankers 1 des Gleichstrommotors unter die durch die unterbrochene Linie 10 dargestellte Bezugsspannung ab, wie dies für den Kurvenpunkt 11 in Figur 2 angedeutet ist, so wird durch den Komparator oder Vergleicher 5 ein Signal entsprechend Figur 2b erzeugt. Das Vergleicherausgangssignal entsprechend Figur 2b in invertierter Form und das Impulsgebersignal entsprechend Figur 2c haben am Ausgang der Registerstufe D des Schieberegisters 7 ein Ausgangssignal entsprechend Figur 2d zur Folge und dieses Signal wird aufgrund der Taktgabe durch den Impulsegeber 8 am Schieberegister 7 durch die Registerstufen geführt und erzeugt an den Ausgängen der Registerstufen E, F und G dann taktweise verschobene Ausgangssignale entsprechend den Figuren 2e, 2f und 2g.

Ein Vor-/Rück-Zähler 12 ist mit seinem Takteingang an den Ausgang der Registerstufe D des Schieberegisters 7 angeschlossen und hat mit seinem Vor-/Rück-Steuereingang Verbindung zu einem die Registerstufen F und G zusammenfassenden ODER-Schaltelement 13.

Die beiden ersten Stufen D und E des Schieberegisters 7 sind ebenfalls durch ein ODER-Schaltelement, nämlich das Schaltelement 14, zusammengefaßt, welches über eine Leitung 15 ein zur impulsweisen Speisung des Gleichstrommotors dienendes Signal an ein UND-Schaltelement 16 abgibt.

Prinzipiell ist es auch möglich, ein Schieberegister mit weniger Stufen zu verwenden und anstelle der Ausgangssignale der ODER-Schaltelemente 13 und 14 jeweils unmittelbar von den Registerstufen abnehmbare Ausgangssignale zu verwenden. Die im vorliegend beschriebenen Ausführungsbeispiel vorgesehene Zusammenfassung der Registerstufen dient dazu, einerseits das Schieberegister 7 mit einem Impulsgeber 8 verhältnismäßig hoher Taktfrequenz steuern zu können, derart, daß verhältnismäßig kurze Zeit nach Auftreten der Unterschreitung der generatorischen Ankerspannung des Ankers 1 relativ zur Bezugsspannung ein den Motor beschleunigender Spannungsimpuls auftritt, andererseits aber der dann ausgelöste, den Gleichstrommotor beaufschlagende Spannungsimpuls eine ausreichende Länge hat.

Aus Figur 1 ist zu erkennen, daß das Schieberegister 7 in Verbindung mit dem Vor-/Rück-Zähler 12 eine Zeitmeßeinrichtung darstellt, welche den zeitlichen Abstand zwischen den Ausgangssignalen des Vergleichers 5 mißt. Gleichzeitig bildet die erste Stufe D des Schieberegisters 7 ein Schaltungselement, welches die Zufuhr des Impulse des Impulsgebers 8 zum Motor hin in Abhängigkeit von dem Auftreten von Ausgangssignalen des Vergleichers 5 steuert.

Der Vor-/Rück-Zähler 12 bietet an seinen Ausgangsleitungen 17 beispielsweise in Binärform Steuersignale dar, die zur Steuerung eines Multiplexers 18 verwendet werden. Die Steuersignale auf den Leitungen 17 sind als Ergebnis der Zeitmessung des zeitlichen Abstandes zwischen den Vergleicherausgangssignalen anzusehen.

Der Multiplexer 18 bildet Bestandteil einer Torschaltsignalquelle 19, deren Aufbau weiter unten näher beschrieben wird. Die Torschaltsignalquelle 19 liefert an ihrem Ausgang 20 das zweite Eingangssignal für das UND-Schaltelement 16 in solcher Weise, daß das aus den Registerstufen D und E mittels der ODER-Schaltelementes 14 zusammengefaßte Signal der Leitung 15 entsprechend Figur 2h eine Aufteilung in Spannungsunterimpulse erfährt, wobei das Puls-/Pausenverhältnis dieser Folge von Spannungsunterimpulsen von den dem Meßergebnis entsprechend den Ausgangssignalen des Vor-/Rück-Zählers 12 auf den Leitungen 17 abhängig ist.

Ist der Abstand zwischen den energiebeaufschlagenden Spannungsimpulsen für den Gleichstrommotor (siehe Figur 2h) größer als ein bestimmter Sollwert, so deutet dies auf einen für einen bestimmten Belastungsfall des Motors zu großen Strom während der Impulsbeaufschlagung des Ankers hin, da aufgrund dieser mit hohem Strom vorgenommenen Impulsbeaufschlagung der Motor und die von ihm angetriebenen Massen stark beschleunigt wurden und dann ein langer Zeitraum verstreicht, bis die generatorische Anker-EMK des Gleichstrommotors unter den eingestellten Sollwert wieder abfällt. In diesem Fall nimmt die Torschaltsignalquelle 19 eine solche Aufteilung des den Motor beaufschlagenden Spannungsimpulses in Spannungsunterimpulse vor, daß das Puls-/Pausenverhältnis einem geringeren durchschnittlichen Motorstrom entspricht. Wenn andererseits die Zeitmeßschaltung meldet, daß ein den Gleichstrommotor beaufschlagender Spannungsimpuls verhältnismäßig rasch auf den vorhergehenden Spannungsimpuls folgt, so nimmt die Torschaltsignalquelle 19 eine Aufteilung des nächstfolgenden Spannungsimpulses zur Beaufschlagung des Gleichstrommotors vor, die ein größeres Puls-/Pausenverhältnis der Spannungsunterimpulse vorsieht, um den durchschnittlichen Strom während der Impulsbeaufschlagung des Motors zu erhöhen, weil die rasche Aufeinanderfolge der motorbeaufschlagenden Impulse darauf hindeutet, daß aufgrund einer erhöhten Motorbelastung die vom Motor angetriebenen Massen verhältnismäßig rasch verzögert werden und daher zur Aufrechterhaltung einer bestimmten Drehzahl oder Fahrgeschwindigkeit oder Arbeitsgeschwindigkeit die Impulsbeaufschlagung des vorausgegangenen Taktes bei dem betreffenden durchschnittlichen Strom nicht ausgereicht hat.

Die Torschaltsignalquelle kann bei dem in Figur 1 gezeigten Ausführungsbeispiel einen Taktgeber 22, einen Taktteiler 23 und eine logische Verknüpfungsschaltung oder Kombinationsschaltung 24 in Reihenschaltung enthalten, welche an ihren Ausgängen Impulsfolgen gleicher Taktfrequenz, jedoch mit schrittweise zunehmendem Puls-/Pausenverhältnis darbietet, wie bei 25 in kleinen Zeitdiagrammen schematisch angedeutet ist. Je nach dem durch die Zeitmeßschaltung ermittelten Meßergebnis bezüglich des zeitlichen Abstandes zwischen den motorbeaufschlagenden Spannungsimpulsen werden durch die Multiplexschaltung 18 entsprechende Ausgangsleitungen der Kombinationsschaltung oder logischen Verknüpfungsschaltung 24 ausgewählt und dienen zur Verknüpfung mit den Signalen der Leitung 15 in dem UND-Schaltelement 16.

## Patentansprüche

1. Verfahren zur Regelung fremderregter Gleichstrommotoren (1), bei welchem an den Anker Spannungsimpulse konstanter Impulsdauer mit einer Impulswiederholungsfrequenz angelegt werden, die von dem Ergebnis eines Vergleiches zwischen der Anker-EMK während der Impulspausen einerseits und einem wählbaren Bezugsspannungswert andererseits abhängig ist, dadurch gekennzeichnet, daß der zeitliche Abstand zwischen den Spannungsimpulsen gemessen wird und die Spannungsimpulse jeweils in Folgen von Spannungsunterimpulsen mit von dem Meßergebnis der Messung des genannten zeitlichen Abstandes abhängigen Puls-/Pausenverhältnis aufgeteilt werden, derart, daß bei großem zeitlichem Abstand zwischen den Spannungsimpulsen das Puls-/Pausenverhältnis der Spannungsunterimpulse verkleinert und bei kleinem zeitlichen Abstand der Spannungsimpulse das Puls-/Pausenverhältnis der Spannungsunterimpulse vergrößert wird.

2. Einrichtung zur Durchführung des Verfahrens nach Anspruch 1, mit einem zur Lieferung der Spannungsimpulse konstanter Dauer dienenden Impulserzeuger (8), von dem die Energie zur Speisung des Ankers des Gleichstrommotors (1) ableitbar ist, ferner mit einem Vergleicher (5), dem einerseits die generatorische Ankerspannung des Gleichstrommotors während der Impulspausen (über 4) und andererseits die wählbare Bezugsspannung (6) zuführbar sind und dessen Ausgang mit Schaltmitteln (D) verbunden ist, welche die Abgabe der Impulse des Impulserzeugers zu dem Gleichstrommotor hin abhängig von den Ausgangssignalen des Vergleichers steuern, gekennzeichnet durch eine Zeitmeßschaltung (7, 12), welche mit dem Ausgang des Vergleichers (5) gekoppelt ist und an ihrem Ausgang vom zeitlichen Abstand der Vergleicherausgangssignale abhängige Steuersignale (17) darbietet, mittels welchen Torschaltsignale einer Torschaltsignalequelle (19) auswählbar sind, die in Torschaltmitteln (16) die den genannten Schaltmitteln (D) nachgeschaltet sind, die Einstellung des Puls-Pausenverhältnisses der von den Torschaltmitteln abnehmbaren Spannungsunterimpulse vornehmen.

3. Einrichtung nach Anspruch 2, dadurch gekennzeichnet, daß die Zeitmeßschaltung ein Schieberegister (7) enthält, dessen erste Stufe (D) die genannten Schaltmittel bildet, dessen Takteingang mit dem Impulserzeuger (8) verbunden ist und dessen Steuereingang an den Vergleicher (5) angeschlossen ist, wobei mindestens eine der ersten Stufe nachgeschaltete Registerstufe an den Vor-/Rück-Steuereingang eines Vor-/Rück-Zählers (12) der Zeitmeßschaltung gelegt ist, deren Takteingang mit dem Ausgang der ersten Stufe des Schieberegisters (7) verbunden ist und welcher an seinen an Zählerstellen entsprechenden Ausgängen die Steuersignale zur Auswahl der Torschaltsignale der Torschaltsignalquelle (19) für die Torschaltmittel (16) darbietet.

4. Einrichtung nach Anspruch 3, dadurch gekennzeichnet, daß die Torschaltsignalquelle (19) einen Taktgeber (22), einen damit verbundenen Taktteiler (23) mit mehreren Ausgängen unterschiedlicher Taktfrequenz und einen daran angeschlossene Verknüpfungsschaltung (24) und hieran angeschlossen einen von den Ausgangssignalen des Vor-/Rück-Zählers gesteuerten Multiplexer enthält.

## Claims

1. Method to control externally excited DC motors (1) where voltage pulses of a constant pulse duration with a pulse repetition frequency which on the one hand is dependent on the result of a comparison between the armature e.m.f. during the interpulse periods and on the other hand on the selectable reference voltage value, are admitted to the armature
**characterized in that**
the time distance between the voltage impulses is measured and the voltage impulses are each time divided into a sequence of voltage subpulses with a pulse/interpulse period relation dependent on the measuring result of the mentioned time distance, such that having a great time distance between the voltage impulses the pulse/interpulse period relation of the voltage subpulses is reduced and having a small time distance of the voltage impulses the pulse/interpulse period relation of the voltage subpulses is increased.

2. Device to carry out the method according to claim 1 with a pulse generator (8) to supply the voltage impulses of a constant duration, from which the energy for feeding the armature of the DC motor (1) can be derived, further with a comparator (5) which on the one hand can be supplied with the generatoric armature voltage of the DC motor during the interpulse periods (via 4) and on the other hand with the selectable reference voltage (6) and exit of which is connected with switching equipment (D) which control the release of the impulses of the pulse generator to the DC motor depending on the exit signals of the comparator,
**characterized by**
a timing circuit (7, 12) which is connected to the comparator (5) and which presents control signals (17) dependent on the time distance of the comparator exit signals at its exit with the help of which gate circuit signals of a gate circuit signal source (19) can be selected, which in gate circuit elements (16) topped by the switching elements (D) adjust the pulse/interpulse period relations of the voltage subpulses which can be taken from the gate circuit elements.

3. Device according to claim 2,
**characterized in that**
the timing circuit contains a shift register (7) the first step (D) of which builds the switching elements mentioned, the cycle entrance of which is connected to the pulse generator (8) and the control entrance of which is connected to the comparator (5) where at least one register level on top of the first step is attached to the forward/backward control entrance of a forward/backward counter (12) of the timing circuit, the cycle entrance of which is conntected to the exit of the first step of the shift register (7) and which at its exits corresponding to the counter positions presents the control signals for selecting the gate circuit signals of the gate circuit signal source (19) for the gate circuit element (16).

4. Device according to claim 3
**characterized in that**
the gate circuit signal source (19) contains a clock generator (22), a clock divider (23) connected therewith with several exits of different clock frequencies and a combinatorial circuit (24) connected thereto and a multiplexer controlled by the exit signals of the forward/backward counter connected thereto.

## Revendications

1. Méthode de réglage de moteur à courant continu à excitation séparée (1), sur l'induit duquel sont appliqués des impulsions de tension de durée constante à une certaine fréquence de répétition dépendant de la comparaison entre la tension génératrice de l'induit pendant les pauses entre les impulsions, d'une part, et une tension de référence prédéterminable, d'autre part, caractérisé en ce que l'écart de temps entre les impulsions est mesuré et les impulsions de tension sont divisés en séquences de sous-impulsions de tension d'un rapport impulsion/pause qui est fonction du résultat de la mesure de cet écart de temps, de telle sorte que, en cas de grand écart de temps entre les impulsions de tension, le rapport impulsion/pause des sous-impulsions est réduit et, en cas de petit écart de temps entre les impulsions de tension, le rapport impulsion/pause des sous-impulsions est augmenté.

2. Dispositif pour la mise en oeuvre de la méthode selon la revendication 1, comprenant un générateur d'impulsions (8) destiné à fournir des impulsions de tension de durée constante, à partir duquel l'induit du moteur à courant continu (1) est alimenté en énergie, un comparateur (5), sur lequel peuvent être amenés d'une part la tension génératrice de l'induit pendant les pauses d'impulsion (par l'intermédiaire de 4) et d'autre part la tension de référence réglable (6) et dont la sortie est reliée à des moyens de réglage (D) qui commandent l'amenée des impulsions du générateur d'impulsions vers le moteur à courant continu en fonction des signaux de sortie du comparateur, caractérisé par un circuit de chronométrage (7, 12) couplé à la sortie du comparateur (5) et fournissant à sa sortie des signaux de commande (17) dépendant de l'écart de temps des signaux de sortie du comparateur, signaux de commande au moyen desquels des signaux de circuit porte d'un générateur de signaux de circuit porte (19) peuvent être sélectionnés qui, dans des circuits porte disposés en aval des moyens de commande (D), effectuent le réglage du rapport impulsion/pause des sous-impulsions fournies par le circuit porte.

3. Dispositif selon la revendication 2, caractérisé en ce que le circuit de mesure du temps comprend un registre à décalage (7) dont le premier échelon (D) forme lesdits moyens de comande, dont l'entrée synchronisatrice est reliée au générateur d'impulsions (8) et dont l'entrée de commande est connectée au comparateur (5), au moins l'un des échelons intercalés à la suite du premier échelon étant relié à l'entrée de commande avant/ arrière d'un compteur avant/arrière (12) du circuit chronométreur dont l'entrée synchronisatrice est reliée avec le premier échelon du registre à décalage (7) et qui, aux sorties correspondant aux circuits compteurs, fournit les signaux de commande pour la sélection des signaux de commande des générateurs de signaux de circuits porte (19) pour les moyens de commande (16) de ces derniers.

4. Dispositif selon la revendication 3, caractérisé en ce que le générateur de signaux de circuit porte (19) comprend une horloge (22), un diviseur de cycle (23) avec plusieurs sorties de fréquence différente et un circuit logique combinatoire (24) branché sur ledit diviseur et un multiplexeur branché sur le circuit logique et commandé par les signaux de sortie du compteur avant/arrière.
